Europäisches Patentamt

European Patent Office

Office européen des brevets

(11) Veröffentlichungsnummer: **0 056 472
B1**

## EUROPÄISCHE PATENTSCHRIFT

(12)

(45) Veröffentlichungstag der Patentschrift:
09.04.86

(21) Anmeldenummer: 81110586.5

(22) Anmeldetag: 18.12.81

(51) Int. Cl.⁴: **H 01 L 27/01**, H 01 L 23/48,
H 05 K 3/16, H 01 B 5/14

(54) Elektronische Dünnschichtschaltung.

(30) Priorität: 15.01.81 DE 3101032
12.09.81 DE 3136198

(43) Veröffentlichungstag der Anmeldung:
28.07.82 Patentblatt 82/30

(45) Bekanntmachung des Hinweises auf die Patenterteilung:
09.04.86 Patentblatt 86/15

(84) Benannte Vertragsstaaten:
CH DE FR GB IT LI NL

(56) Entgegenhaltungen:
DE - A - 2 040 746
DE - A - 2 509 912
DE - A - 2 849 971
DE - A - 2 906 813
DE - B - 2 606 086
US - A - 3 872 356

(73) Patentinhaber: **ROBERT BOSCH GMBH, Postfach 50,
D-7000 Stuttgart 1 (DE)**

(72) Erfinder: Küttner, Klaus, Engelbergstrasse 28,
D-7000 Stuttgart 31 (DE)

LIBER, STOCKHOLM 1986

## Beschreibung

### Stand der Technik

Die Erfindung geht aus von einer elektronischen Dünnschichtschaltung nach der Gattung des Hauptanspruchs. Aus der DE-A-25 09 912 ist bereits eine elektronische Dünnschichtschaltung dieser Art bekannt. Bei dieser Dünnschichtschaltung ist auf die auf den zweiten Bereich der Ventilmetallschicht aufgebrachte Metallisierung eine weitere Metallschicht, insbesondere Gold-Nickel-Schicht aufgebracht, wodurch die Benetzbarkeit der Metallisierung mit flüssigem Lot und damit die Haftfestigkeit einer aufzubringenden Weichlotschicht verbessert werden. Der Nickel-Schicht fällt bei dieser Anordnung die Aufgabe einer Diffusionssperrschicht zu. Der Widerstand und damit die Leitfähigkeit der Leiterbahnen wird im wesentlichen durch die Dicke der auf die Metallschicht aufgebrachte Lotschicht bestimmt. Derartige Weichlotschichten haben aber den Nachteil, daß ihr Auftrag schwankend und ungleichmäßig und vielfach relativ dünn ist. Beim Aufbringen der elektrischen Bauelemente im Reflow-Lötverfahren beeinflussen diese zusätzlich die Schichtdicke der Weichlotschicht, indem sie einen Teil des Lotes von den Anschlußkontakten und Leiterbahnen abziehen, was zu einer mangelnden Leitfähigkeit der Leiterbahnen und An-schlußkontakte und häufig zum Ausfall der elektronischen Dünnschichtschaltung führt.

### Vorteile der Erfindung

Die erfindungsgemäße Dünnschichtschaltung mit den kennzeichnenden Merkmalen des Anspruchs 1 hat demgegenüber den Vorteil, daß bei ihr die durch die Verstärkungsschicht verstärkten Leiterbahnen und Anschlußkontakte durchweg eine ausreichende Leitfähigkeit besitzen und daß diese Leitfähigkeit unabhängig von der Verbindungstechnik ist, die zur äußeren Verbindung der Dünnschichtschaltung mit ihrer Umgebung und zur Aufbringung der elektrischen Bauelemente dient. Beide Verbindungen können also ohne Schwierigkeit wahlweise entweder im Reflow-Lötverfahren oder in chipund-wire-Bondtechnik ausgeführt werden.

### Zeichnung

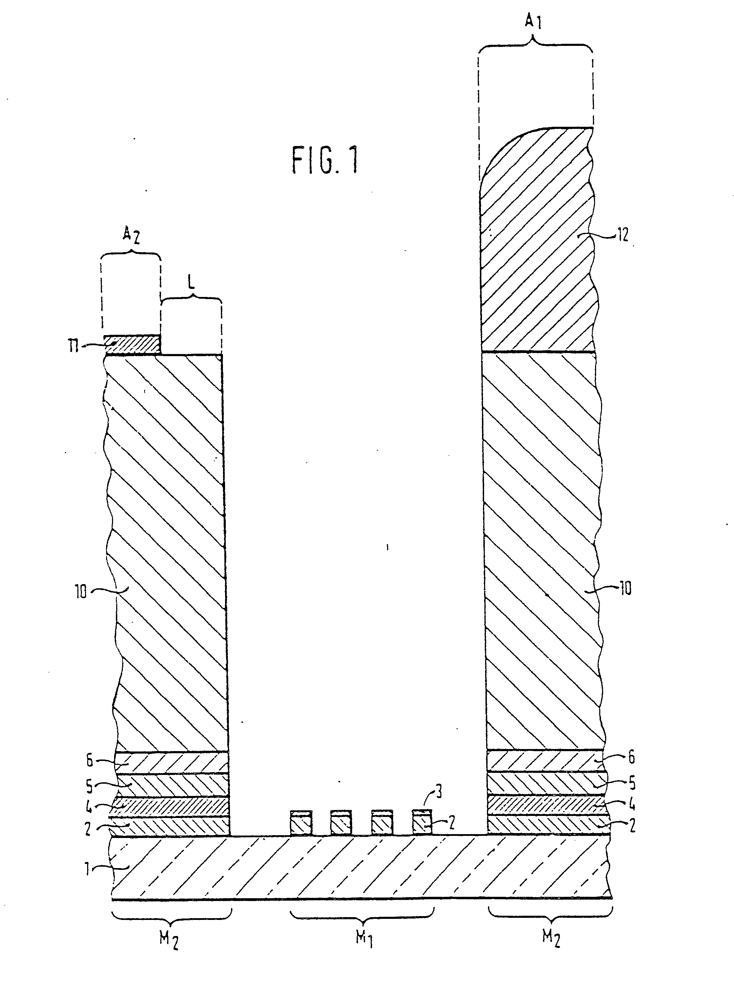

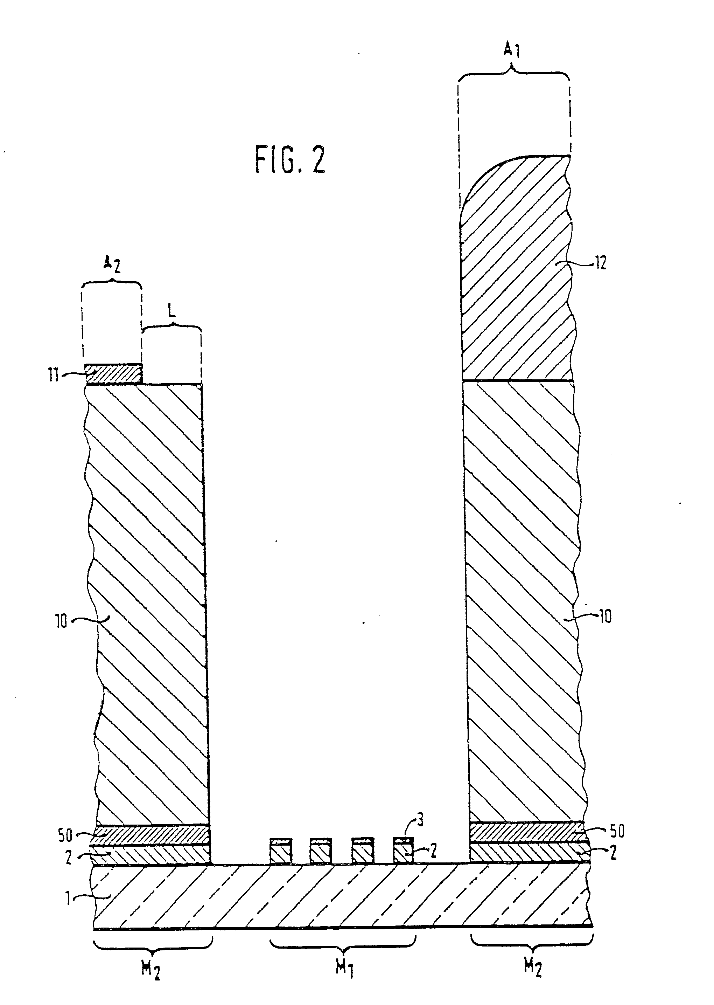

Zwei Ausführungsbeispiele der erfindungsgemäßen Dünnschichtschaltung sind in der Zeichnung dargestellt und in der nachfolgenden Beschreibung näher erläutert. Die Figuren 1 und 2 zeigen jeweils einen Teilschnitt durch ein Ausführungsbeispiel einer elektronischen Dünnschichtschaltung gemäß der Erfindung, das als Schaltungsnetzwerk ein Widerstandsnetzwerk enthält.

### Beschreibung der Ausführungsbeispiele

Gemäß Figur 1 ist auf ein aus einem isolierenden Substrat bestehendes Trägerplättchen 1 eine die Grundgeometrie des Schaltungsnetzwerks enthaltende Schicht 2 aus Ventilmetall von 1000 Ü Dicke durch Kathodenzerstäubung aufgebracht. Unter Ventilmetall versteht man ein Metall, das ein einen Gleichstrom sperrendes Oxid bildet. Vorzugsweise ist als Ventilmetall Tantal vorgesehen. Statt dessen können aber auch die Metalle Niob, Aluminium, Zirkonium und Hafnium verwendet werden. Die Ventilmetallschicht 2 trägt an denjenigen Oberflächenbereichen $M_1$, die das Widerstandsnetzwerk bilden, keine weitere Metallisierung. Die Ventilmetallschicht 2 kann aber im Bereich dieses Musters $M_1$ eine Oxidschicht 3 tragen, die dadurch hergestellt sein kann, daß die Ventilmetallschicht 2 an diesen Stellen teilweise anodisch oxidiert ist.

Die Ventilmetallschicht 2 trägt dagegen an denjenigen Oberflächenbereichen $M_2$, die nicht zum Widerstandsnetzwerk gehören, eine aus den Schichten 4, 5, 6 bestehende, als Haftvermittler dienende Metallisierung. Die Schichten 4, 5, 6 sind dabei ebenfalls durch Kathodenzerstäubung aufgebracht. Die erste Schicht 4 und die dritte Schicht 6 dieser Metallisierung sind Kupferschichten von jeweils 2000 Ü Dicke. Die zwischen diesen beiden Kupferschichten 4 und 6 verlaufende Zwischenschicht 5 besteht aus einem als Diffusionssperre wirkenden Metall, beispielsweise aus Eisen, Nickel oder Kobalt. Die Dicke dieser Schicht 5 beträgt 4000 Ü.

Die weitere, verglichen mit dem Schichtsystem 4, 5, 6 erheblich dickere Schicht 10 ist eine galvanisch aufgebrachte Kupferschicht und hat im vorliegenden Ausführungsbeispiel eine Dicke von 4 μm. Sie dient im Bereich des Musters $M_2$ als Verstärkungsschicht für das Schichtsystem 2, 4, 5, 6.

Das aus der Metallisierung 4, 5, 6 und aus der Verstärkungsschicht 10 bestehende Schichtsystem ist an allen denjenigen Stellen auf die Ventilmetallschicht 2 aufgebracht, die für Leiterbahnen L und für Anschlußkontakte $A_1$, $A_2$ vorgesehen sind. Im Bereich der Leiterbahnen L ist dabei die Verstärkungsschicht 10 unbeschichtet. Im Bereich der für Weichlotkontaktierung vorgesehenen Anschlußkontakte $A_1$ ist auf die Verstärkungsschicht 10 zusätzlich eine Weichlotschicht 12 aufgebracht. Im Bereich der für Bondkontaktierung vorgesehenen Anschlußkontakte $A_2$ ist auf die Verstärkungsschicht 10 zusätzlich eine Goldschicht 11 aufgebracht.

Die nicht mit den Schichten 4, 5, 6, 10, 11, 12 bedeckten, jedoch gegebenenfalls mit einer Oxidschicht 3 behafteten Teile $M_1$ der

Ventilmetallschicht 2 bilden das Widerstandsnetzwerk der Dünnschichtschaltung.

Beim Ausführungsbeispiel nach Fig. 2 ist die dreischichtige Metallisierung 4, 5, 6 durch eine einzige Schicht 50 ersetzt, die aus Nickel besteht. Die Dicke dieser Schicht beträgt 4000 Ü.

Bei der Herstellung der erfindungsgemäßen Dünnschichtschaltung kann wie folgt verfahren werden:

Die Substratplatte 1 wird zunächst ganzflächig mit dem Schichtsystem 2, 4, 5, 6, 10 bzw. mit dem Schichtsystem 2, 50, 10 belegt. In einem oder mehreren Verfahrensschritten wird dann die Grundgeometrie der Dünnschichtschaltung herausgeätzt. Nach dem Ablösen der ersten Photomaske wird eine zweite Maske aufgebracht, die selektiv die Fläche für die Widerstandsmäander freilegt, die Leiterbahnen und Anschluß-kontakte aber abdeckt. Mittels eines selektiven Ätzmittels wird sodann die Leiterschicht 4, 5, 6, 10 bzw. 50, 10 von der Widerstandsmäanderfläche entfernt. Zur Herstellung der Widerstandsmäander aus der Widerstandsmäanderfläche wird eine dritte Photomaske aufgebracht. Diese enthält die Widerstandsgeometrie; sie deckt die Leiterbahnen und An-schlußkontakte ab. Anschließend wird die Widerstandsgeometrie herausgeätzt. Ist ein Widerstandsabgleich erforderlich, so kann dies mit den bekannten Verfahren wie Abgleich durch Laser, Sandstrahlen oder anodisch Oxidation durchgeführt werden. Im zuletzt genannten Fall der anodischen Oxidation bildet sich dann die Ventilmetalloxidschicht 3.

Zum Widerstandsabgleich durch anodische Oxidation benötigt man eine Abdeckmaske für die nicht abzugleichenden Bereiche sowie für die Leiterbahnen und Anschlußkontakte. Unter Verwendung des mehrfach belichtbaren Positiv-Photolackes wird, ausgehend von dem Fertigungsstand, über einen nachfolgenden photolithografischen Prozeß der Photolack von den Widerstandsbahnen entfernt.

Ein nach diesem Verfahren erzeugtes Dünnschichtwiderstandsnetzwerk ist Ausgangspunkt für

(a) Dünnschichthybride in Reflow-Löt-Technik:
Nach dem Aufbringen einer Lötstoppmaske auf die Bereiche der Kupferschicht 10, die nicht mit Lot benetzt werden sollen, wird das Netzwerk in ein Blei-Zinn-Weichlotbad getaucht. Dabei entsteht auf den mit Lot zu belegenden Bereichen $A_1$ eine Blei-Zinn-Weichlotschicht 12.

(b) Dünnschichthybride in chip- und wire-Technik:
In der chip- und wire-Technik ist es vorteilhaft, auf einer Gold-Oberfläche zu bonden. Dazu wird auf alle diejenigen Bereiche $A_2$ eine electroless-Gold-Schicht 11 von ca. 1 µm aufgetragen, auf denen Brücken- oder chip-Bonds gesetzt werden sollen. Eine Galvanomaske deckt dabei diejenigen Bereiche ab, die nicht mit Gold belegt werden sollen.

Die Erfindung ist nicht auf die anhand der Zeichnung beschriebenen Ausführungsbeispiele beschränkt.

Beispielsweise kann als Widerstandsschicht anstelle der Ventilmetallschicht 2 eine Ventilmetallnitridschicht, insbesondere eine Schicht aus Tantalnitrid, oder eine Ventilmetalloxinitridschicht, insbesondere eine Schicht aus Tantaloxinitrid, verwendet werden. Derartige Schichten können in derselben Weise Schaltelemente einer elektronischen Dünnschichtschaltung bilden wie Ventilmetallschichten.

Das erfindungsgemäße Dünnschicht-Widerstandsnetzwerk hat den wesentlichen Vorteil, daß die Leitfähigkeit der Leiterbahnen L unabhängig vom Lotbelegungsverfahren ist, weil das Weichlot 12 ausschließlich auf die zur Weichlotkontaktierung dienenden Anschlußkontakte $A_1$ aufgebracht wird und nur zur Verbindung der Bauelemente oder äußeren Zuleitungen mit dem Netzwerk der Dünnschichtschaltung im Reflow-Lötverfahren, nicht aber gleichzeitig zur Herstellung ausreichender Leitfähigkeit der Leiterbahnen L dient.

**Patentansprüche**

1. Elektronische Dünnschichtschaltung mit einer aus einem Isoliermaterial bestehenden Substratplatte (1), mit einer die Substratplatte (1) in Form eines ersten ($M_1$) und eines zweiten ($M_2$) Musters teilweise bedeckenden, eine Dicke in der Größenordnung von einem oder mehreren Zehntel-µm aufweisenden Ventilmetallschicht (2), wobei diese beiden Muster ($M_1$, $M_2$) an mindestens einer Stelle zusammenhängen und einen ersten und einen zweiten Bereich der Ventilmetallschicht (2) bilden, von denen der erste Bereich ($M_1$) Schaltelemente der elektronischen Dünnschichtschaltung und der zweite Bereich ($M_2$) Anschlußkontakte ($A_1$, $A_2$) und Verbindungsleitungen (L) definiert, mit einer, eine Dicke in der Größenordnung von einem oder mehreren Zehntel-µm aufweisenden Metallisierung (4, 5, 6; 50) auf dem zweiten Bereich ($M_2$) der Ventilmetallschicht (2) und mit einer weiteren, als Verstärkungsschicht dienenden, beim Lötprozeß nicht schmelzenden und auf die Metallisierung (4, 5, 6; 50) aufgebrachten Metallschicht (10), dadurch gekennzeichnet, daß die weitere, auf die Metallisierung (4, 5, 6; 50) aufgebrachte Metallschicht (10) eine Dicke von wenigstens 2 µm aufweist.

2. Elektronische Dünnschichtschaltung nach Anspruch 1, dadurch gekennzeichnet, daß die weitere Metallschicht (10) im Bereich der Leiterbahnen (L) unbeschichtet ist.

3. Elektronische Dünnschichtschaltung nach Anspruch 1 oder 2, dadurch gekennzeichnet, daß die weitere Metallschicht (10) im Bereich von Anschlußkontakten ($A_1$), die zum Anlöten von Teilen im Reflow-Lötverfahren dienen, eine Weichlotschicht (12) trägt.

4. Elektronische Dünnschichtschaltung nach wenigstens einem der Ansprüche 1 bis 3, dadurch gekennzeichnet, daß die weitere Metallschicht (10) im Bereich von Anschluß-kontakten ($A_2$), die zum Anschluß von Elementen in chipund-wire-Bondtechnik dienen, eine Goldschicht (11) trägt.

5. Elektronische Dünnschichtschaltung nach einem der Ansprüche 1 bis 4, dadurch gekennzeichnet, daß die Ventilmetallschicht (2) und die Metallisierung (4, 5, 6; 50) durch Kathodenzerstäubung aufgebracht sind.

6. Elektronische Dünnschichtschaltung nach einem der Ansprüche 1 bis 5, dadurch gekennzeichnet, daß die weitere Metallschicht (10) galvanisch aufgebracht ist.

7. Elektronische Dünnschichtschaltung nach einem der Ansprüche 1 bis 6, dadurch gekennzeichnet, daß die weitere Metallschicht (10) aus Kupfer besteht.

8. Elektronische Dünnschichtschaltung nach einem der Ansprüche 1 bis 7, dadurch gekennzeichnet, daß die Metallisierung (50) einschichtig ist und aus Nickel besteht (Figur 2).

## Claims

1. Electronic thin-film circuit comprising a substrate plate (1) consisting of an insulating material, and comprising a valve-metal layer (2) which has a thickness of the order of magnitude of one or more tenths μm and partially covers the substrate plate (1) in the form of a first ($M_1$) and a second ($M_2$) pattern, in which arrangement these two patterns ($M_1$, $M_2$) are joined together at at least one place and form a first and a second area of the valve-metal layer (2), the first area ($M_1$) of which defines switching elements of the electronic thin-film circuit and the second area ($M_2$) of which defines connecting contacts (A1, A2) and connecting lines (L), with a metallization (4, 5, 6; 50) having a thickness of the order of magnitude of one or more tenths μm on the second area ($M_2$) of the valve-metal layer (2) and having a further metal layer (10) which has been applied to the metallisation (4, 5, 6; 50), does not melt during the soldering process and serves as reinforcing layer, characterized in that the further metal layer (10) applied to the metallization (4, 5, 6; 50) has a thickness of at least 2 μm.

2. Electronic thin-film circuit according to Claim 1, characterized in that the further metal layer (10) is uncoated in the area of the conductor tracks (L).

3. Electronic thin-film circuit according to Claim 1 or 2, characterized in that the further metal layer (10) carries a soft-solder layer (12) in the area of connecting contacts ($A_1$) serving to solder on parts by the reflow-soldering method.

4. Electronic thin-film circuit according to at least one of Claims 1 to 3, characterized in that the further metal layer (10) carries a gold layer (11) in the area of connecting contacts ($A_2$) which are used for connecting elements by the chip-and-wire bonding technique.

5. Electronic thin-film circuit according to one of Claims 1 to 4, characterized in that the valve-metal layer (2) and the metallization (4, 5, 6; 50) have been applied by cathode sputtering.

6. Electronic thin-film circuit according to one of Claims 1 to 5, characterized in that the further metal layer (10) has been applied by electrodeposition.

7. Electronic thin-film circuit according to one of Claims 1 to 6, characterized in that the further metal layer (10) consists of copper.

8. Electronic thin-film circuit according to one of Claims 1 to 7, characterized in that the metallization (50) is a single layer and consists of nickel (Figure 2).

## Revendications

1°) Circuit électronique à film mince composé d'une plaque de support (1) en un matériau isolant, une couche de métal de barrage (2), recouvrant partiellement la plaque de support (1) sous la forme d'un premier modèle ($M_1$) et un second modèle ($M_2$) et ayant une épaisseur de l'ordre d'un à plusieurs dizaines de microns, ces deux modèles ($M_1$, $M_2$) formant au moins à un endroit des liaisons et une première et une seconde zone de la couche de métal de barrage (2) parmi lesquelles la première zone ($M_1$) définit des composants du circuit électronique à film mince et la seconde zone ($M_2$) des contacts de branchement ($A_1$, $A_2$) et des lignes de liaison (L), avec une métallisation (4, 5, 6; 50) ayant une épaisseur de l'ordre de grandeur d'un ou plusieurs dizièmes de microns et prévue sur la seconde zone ($M_2$) de la couche de métal de barrage (2) et d'une autre couche métallique (10), servant de couche de renforcement, qui ne fond pas à la brasure et qui est prévue sur la métallisation (4, 5, 6; 50), caractérisé en ce que cette autre couche métallique (10) prévue sur la métallisation (4, 5, 6; 50) a une épaisseur d'au moins 2 microns.

2°) Circuit électronique à film mince selon la revendication 1, caractérisé en ce que l'autre couche métallique (10) n'est pas revêtue dans la zone des chemins conducteurs (L).

3°) Circuit électronique à film mince selon la revendication 1 ou 2, caractérisé en ce que l'autre couche métallique (10) porte au niveau des contacts de branchement ($A_1$), une couche de brasure (12) pour la brasure de pièces selon le procédé de soudure à la vague.

4°) Circuit électronique en film mince selon au moins l'une des revendications 1 à 3, caractérisé en ce que l'autre couche métallique (10) porte au niveau des contacts de branchement ($A_2$) une couche d'or (11) servant au branchement d'éléments selon la technique des plaquettes et des câbles.

5°) Circuit électronique à film mince selon l'une des revendications 1 à 4, caractérisé en ce que la couche de métal de barrage (2) et la métallisation (4, 5, 6; 50) sont appliquées par pulvérisation cathodique.

6°) Circuit électronique à film mince selon l'une des revendications 1 à 5, caractérisé en ce que l'autre couche métallique (10) est appliquée par voie galvanique.

7°) Circuit électronique à film mince selon l'une des revendications 1 à 6, caractérisé en ce que l'autre couche métallique (10) est en cuivre.

8°) Circuit électronique à film mince selon l'une des revendications 1 à 7, caractérisé en ce que la métallisation (50) est une couche unique en nickel (figure 2).

FIG. 1

# FIG. 2